# EUROPEAN PATENT SPECIFICATION

(11) **EP 2 908 175 B1**
(45) Date of publication and mention of the grant of the patent: **12.06.2019**
(21) Application number: 13843299.2
(22) Date of filing: 26.09.2013
(51) Int. Cl.: G03F 7/20, B29C 59/02, H01L 21/027

(54) **MICRO-STRUCTURE BODY FABRICATION METHOD**
HERSTELLUNGSVERFAHREN EINES MIKROSTRUKTURKÖRPERS
PROCÉDÉ DE FABRICATION DE CORPS À MICROSTRUCTURES

(30) Priority: 01.10.2012 JP 2012219440
(43) Date of publication of application: 19.08.2015
(73) Proprietor: Kuraray Co., Ltd., Kurashiki-shi, Okayama 710-0801 (JP)
(72) Inventor: WATANABE, Junji, Kamisu-shi, Ibaraki 314-0197 (JP); KARAI, Masaru, Kamisu-shi, Ibaraki 314-0197 (JP)
(74) Representative: Müller-Boré & Partner Patentanwälte PartG mbB
(86) International application number: PCT/JP2013/005711
(87) International publication number: WO 2014/054250

(56) References cited:
- JP-A- S6 299 753
- JP-A- 2001 311 811
- JP-A- 2004 334 184
- JP-A- 2008 070 741
- JP-A- 2012 037 729
- US-A- 5 407 785
- US-A1- 2010 099 034
- US-A1- 2011 195 363
- HUNG-LIN YIN ET AL: "The Study on 3D Electron Beam Lithography for Sub-micrometer Diffractive Optics", OPTICAL MEMS AND NANOPHOTONICS, 2007 IEEE/LEOS INTERNATIONAL CONFERENC E ON, IEEE, PI, 1 August 2007 (2007-08-01), pages 149-150, XP031155612, ISBN: 978-1-4244-0641-8
- JIAN JIM WANG ET AL: "Nano-and Microlens Arrays Grown Using Atomic-Layer Deposition", IEEE PHOTONICS TECHNOLOGY LETTERS, IEEE SERVICE CENTER, PISCATAWAY, NJ, US, vol. 18, no. 24, 15 December 2006 (2006-12-15), pages 2650-2652, XP011151581, ISSN: 1041-1135, DOI: 10.1109/LPT.2006.887775

## Description

The present invention relates to a microstructure production method including a photoresist pattern forming step.

There is a microstructure production method including a photoresist pattern forming step in which a positive photoresist, which is applied onto a base material, is exposed by scanning laser light, while the amount of laser light is modulated, and the photoresist is then developed, to thereby form a photoresist pattern having a desired pattern with a concave and convex on the base material.

In this method, the height or slope form of a pattern to be formed varies depending on the amount of exposure (amount of laser light) applied to the photoresist and the dissolution characteristics of the photoresist during the development thereof. Accordingly, the amount of exposure (amount of laser light) is adjusted according to the height or slope form of the pattern to be formed.

Unless otherwise stated, the term "photoresist" used herein refers to a positive photoresist.

Patent Literature 1 and 2 (Figs 2 and 3 of Patent Literature 1 and Figs. 3 and 6 of Patent Literature 2) discloses a microstructure production method in which a photoresist pattern is obtained by the above-mentioned method; a stamper made of nickel is obtained using the photoresist pattern; and the pattern is transferred onto a resin by using the stamper.

Patent Literature 1 (for example, Claim 1 of Patent Literature 1) discloses a method for setting a focal position within a resist as a countermeasure against deterioration in resolution during the process of exposure of the photoresist by scanning laser light.

Patent Literature 2 (for example, Claim 12) discloses a method for performing the exposure of the photoresist multiple times by changing the focal position so as to suppress the deterioration in resolution due to defocusing, when a concave portion having a depth greater than the focal depth of the laser light is formed during the exposure of the photoresist by scanning the laser light.
Patent Literature 3 describes a method of compensation for bleaching of resist during three-dimensional exposure of resist. Patent Literature 4 discloses a method for generating dense lines on a semiconductor wafer using phase-shifting and multiple exposures.

[Patent Literature 1] Japanese Unexamined Patent Application Publication No.2003-43698
[Patent Literature 2] Japanese Unexamined Patent Application Publication No.2004-46003
[Patent Literature 3] US 2010/099034 A1
[Patent Literature 4] US 5 407 785 A

In Patent Literature 1 and 2, defocusing is suppressed by adjusting the focal position during the exposure of the photoresist by scanning laser light, to thereby improve the resolution.

However, in the case of exposing a photoresist to light by modulating the amount of laser light (laser light intensity), there is an upper limit to the number of gradations at which the amount of laser light (corresponding to laser power) can be modulated, and thus, in some cases, it is difficult to obtain a sufficient resolution due to an insufficient number of gradations for modulation of the amount of laser light, rather than the effect of the focal position. To increase the number of gradations for modulation of the amount of laser light, much cost and time are required for modification of hardware or software of a device. Accordingly, if an insufficient resolution is caused due to an insufficient number of gradations of the amount of laser light, it is difficult to improve the insufficient resolution.

Hereinafter, the deterioration in resolution due to an insufficient number of gradations for modulation of the amount of laser light will be described using specific examples.

For example, in the case of forming a hemispherical convex portion, since there is a distribution in height of the convex portion, the surface of the hemispherical convex portion can be theoretically made into a smoothly curved surface by modulating the amount of laser light according to the height. However, in practice, since there is an upper limit to the number of gradations for modulation of the amount of laser light, it is difficult to obtain a smoothly curved surface.

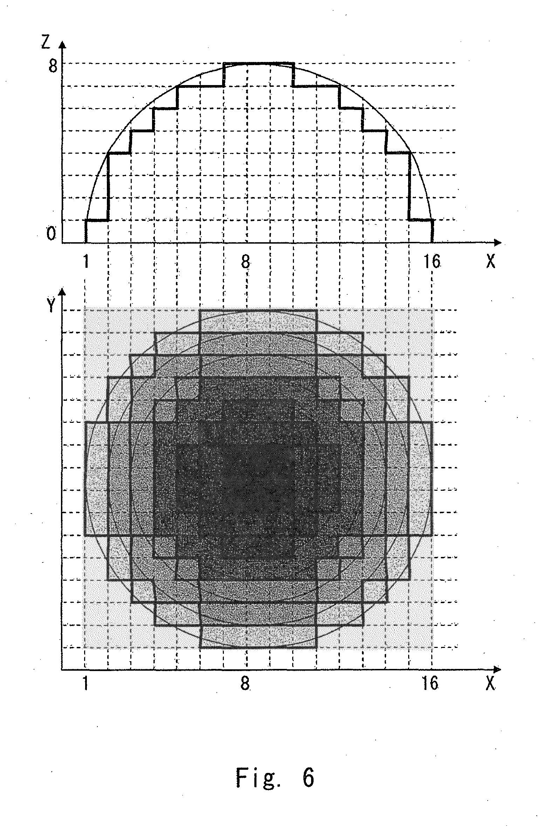

Fig. 6 shows an example of setting the gradation for modulation of the amount of laser light in the case of forming a hemispherical convex portion.

In this case, the bottom surface of the hemispherical convex portion is defined as an XY plane, and the height direction of the hemispherical convex portion is defined as a Z-axis direction.

The upper figure in Fig. 6 shows a most ideal laser light amount distribution (thin line) for obtaining a desired shape and an actual laser light amount distribution (thick line) in the XZ plane passing through the center of the convex portion obtained after the development of the photoresist of the photoresist.

The lower figure in Fig. 6 shows the most ideal laser light amount distribution (thin line) for obtaining a desired shape and the actual laser light amount distribution (thick line), when viewed from the vertex of the convex portion. In this figure, the area is divided into sections according to the gradation of the amount of laser light, and the magnitude of the amount of laser light in each section is represented by gradation. In this figure, the sections with a larger quantity of laser light are displayed with darker colors.

The horizontal axis in each of the upper and lower figures in Fig. 6 is expressed in units of "µm".

In the device of this example, eight gradations for modulation of the amount of laser light can be set. The gradations can be set every 1 µm in each of the X-axis direction and the Y-axis direction.

In the case of forming a hemispherical convex portion as shown in the lower figure in Fig. 6, a desired exposure shape when viewed from the vertex of the convex portion is a circular shape. However, since the gradations in each of the X-axis direction and the Y-axis direction are set every 1 µm, the exposure shape obtained when the gradation is actually set is not a completely circular shape, but the difference between the exposure shape and the circular shape is the minimum one.

On the other hand, also in the case of setting the gradation of the amount of laser light in the XZ plane, it is ideal to set the gradation in a semicircular shape as shown in the upper figure in Fig. 6. However, in practice, since there is an upper limit to the number of gradations that can be set, the gradation is set in a step-like shape as indicated by the thick line in the figure.

Further, in this example, since the gradations are set every 1 µm in each of the X-axis direction and the Y-axis direction, only six gradations out of eight gradations at maximum can be used as the gradation of the amount of laser light in each gradation section.

In the case of an example shown in Fig. 6, on the surface (three-dimensional curved surface) of the convex portion obtained after the development of the photoresist, a desired resolution cannot be obtained in some cases due to, for example, generation of a step at a boundary portion between the gradations to be set.

The present invention has been made in view of the above-mentioned circumstances, and an object of the present invention is to provide a microstructure production method which includes a photoresist pattern forming step and is capable of substantially increasing the number of gradations of the amount of laser light by a simple method during a photoresist exposure process, thereby improving the resolution.

A microstructure production method according to the present invention includes a photoresist pattern forming step of irradiating a positive photoresist applied onto a base material with laser light while scanning the laser light to expose the photoresist to light, and developing the photoresist, thereby forming a photoresist pattern having a surface patterned with a concave and convex.

In the microstructure production method, in the photoresist pattern forming step, an overlay exposure process in which exposure of a plurality of gradations with a modulated amount of laser light depending on an in-plane position of the base material is carried out one upon another and multiple times is performed by setting gradation patterns with different relations between the in-plane position of the base material and the amount of laser light so that the number of gradations of a total amount of exposure in the overlay exposure process is increased compared to the number of gradations of the modulation of the amount of the laser light, and the concave and convex pattern according to the total amount of exposure in the overlay exposure process is formed after developing the photoresist, and in the overlay exposure process, the exposure of the photoresist is carried out one upon another by using exposure pattern data different from that used in a previous exposure as exposure pattern data representing a relation between a relative position and the amount of laser light, or is carried out one upon another by using the same exposure pattern data as that used in a previous exposure as exposure pattern data representing a relation between a relative position and the amount of laser light and by shifting the in-plane position of the base material of the exposure pattern data.

In the exposure of the photoresist, under the same laser light irradiation conditions of, for example, a scanning rate, a laser light intensity distribution (objective lens numerical aperture), and a laser light scanning pitch, except that only laser power is changed, the "amount of laser light" corresponds to the laser power.

The microstructure production method according to the present invention may further include a stamper forming step of forming a stamper on the photoresist pattern along a pattern shape of the photoresist pattern, and separating the stamper from the photoresist pattern.

The microstructure production method according to the present invention may further include a resin transfer step of transferring a pattern onto a resin by using a duplicate stamper, the duplicate stamper being obtained by turning over the stamper or a pattern shape of the stamper one or more times.

A microstructure described herein is produced by the above-mentioned production method of the present invention.

The microstructure described herein is a microstructure produced by the production method which includes the above-mentioned photoresist pattern forming step, and optionally includes a stamper forming step and a resin transfer step.

Examples of the microstructure described herein include a photoresist pattern itself, a stamper produced by using the photoresist pattern, a duplicate stamper obtained by turning over the pattern shape of the stamper one or more times, and a resin molding produced by transferring a pattern onto a resin by using the stampers.

According to the present invention, it is possible to provide a microstructure production method which includes a photoresist pattern forming step and is capable of substantially increasing the number of gradations of the amount of laser light by a simple method during exposure of a photoresist, to thereby improve the resolution.

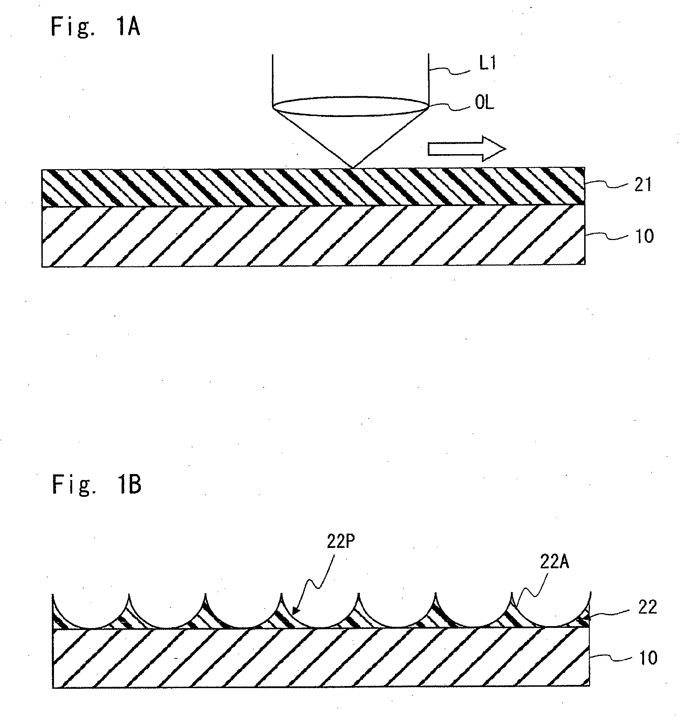

Fig. 1A is a production process flow chart showing a microstructure according to an embodiment of the present invention;
Fig. 1B is a production process flow chart showing the microstructure according to an embodiment of the present invention;

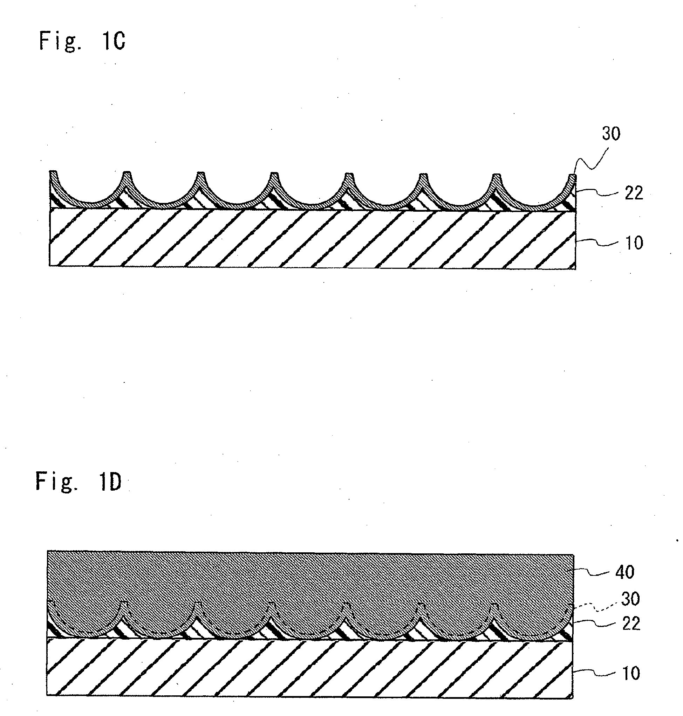

Fig. 1C is a production process flow chart showing the microstructure according to an embodiment of the present invention;
Fig. 1D is a production process flow chart showing the microstructure according to an embodiment of the present invention;

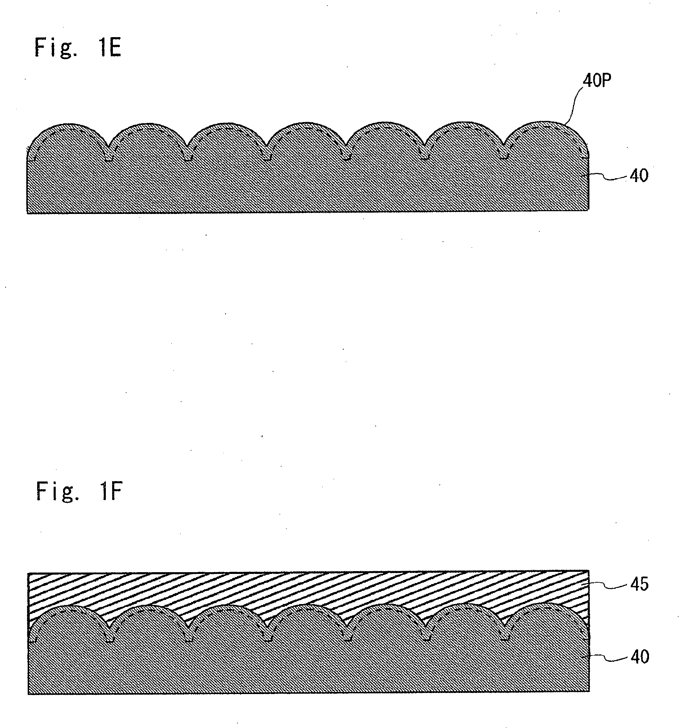

Fig. 1E is a production process flow chart showing the microstructure according to an embodiment of the present invention;
Fig. 1F is a production process flow chart showing the microstructure according to an embodiment of the present invention;

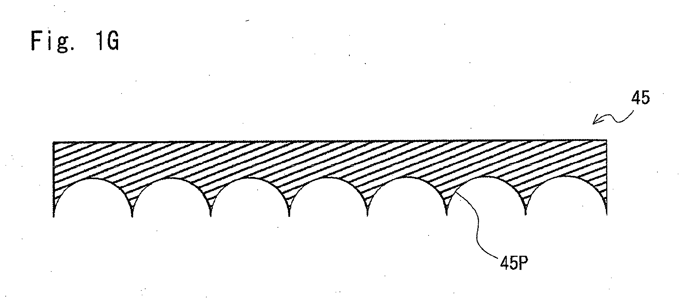

Fig. 1G is a production process flow chart showing the microstructure according to an embodiment of the present invention;

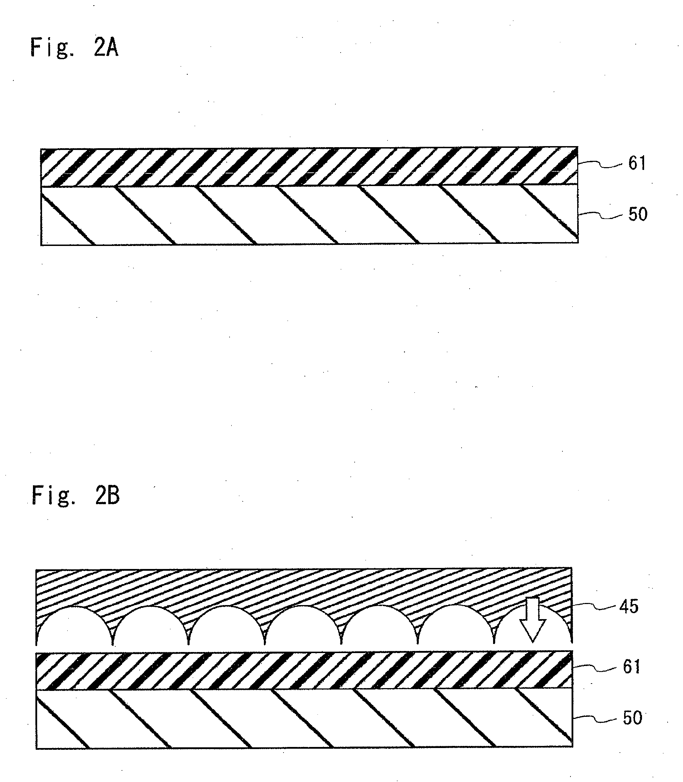

Fig. 2A is a production process flow chart showing the microstructure according to an embodiment of the present invention;
Fig. 2B is a production process flow chart showing the microstructure according to an embodiment of the present invention;

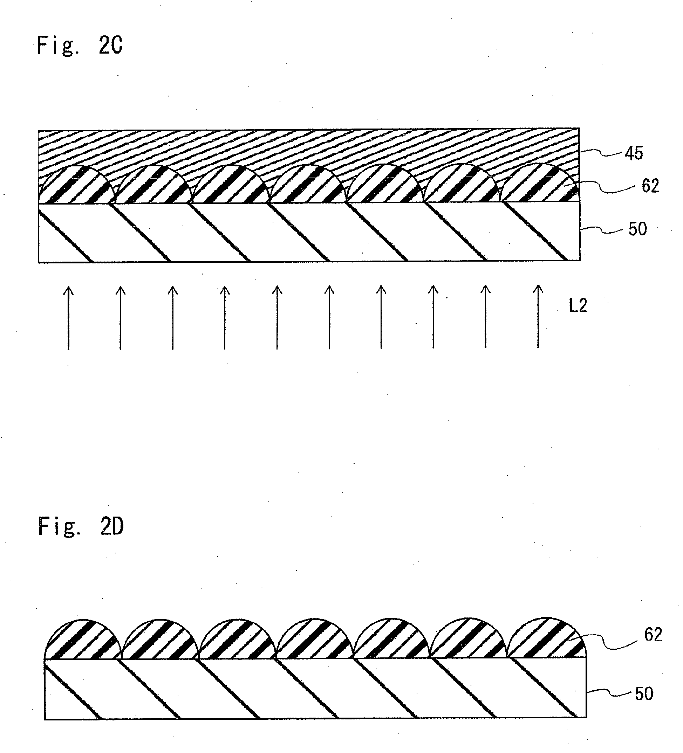

Fig. 2C is a production process flow chart showing the microstructure according to an embodiment of the present invention;
Fig. 2D is a production process flow chart showing the microstructure according to an embodiment of the present invention;

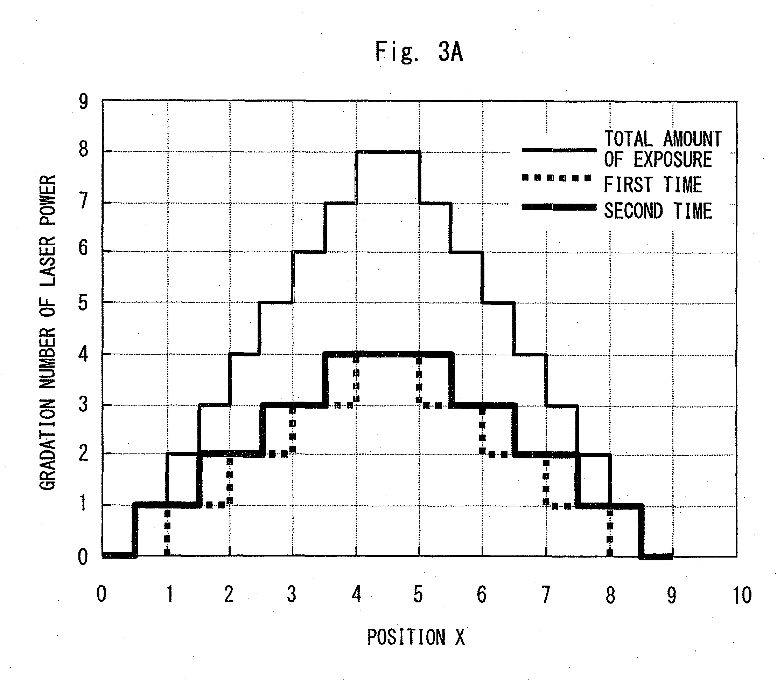

Fig. 3A is a graph showing an example of gradation setting in an overlay exposure process of a microstructure production method according to an embodiment of the present invention;

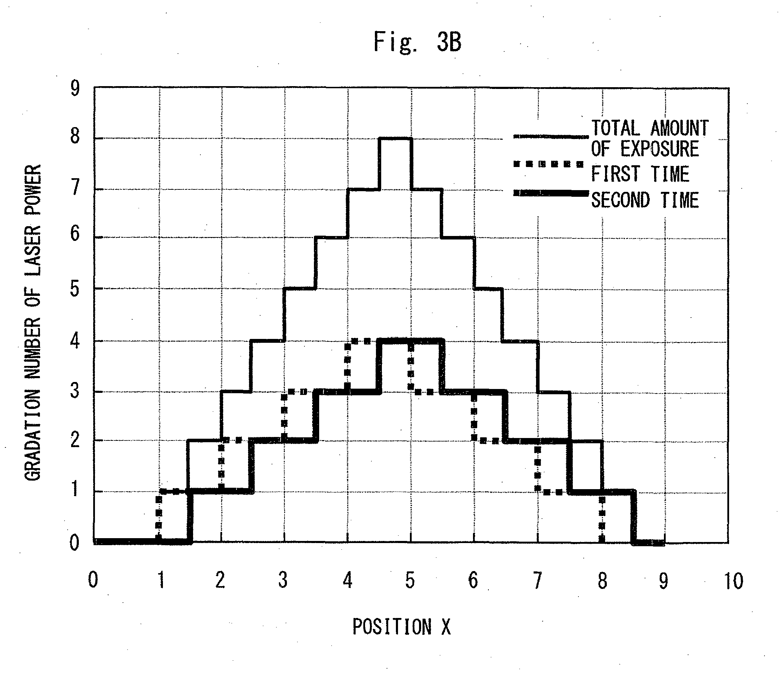

Fig. 3B is a graph showing another example of gradation setting in the overlay exposure process of the microstructure production method according to an embodiment of the present invention;

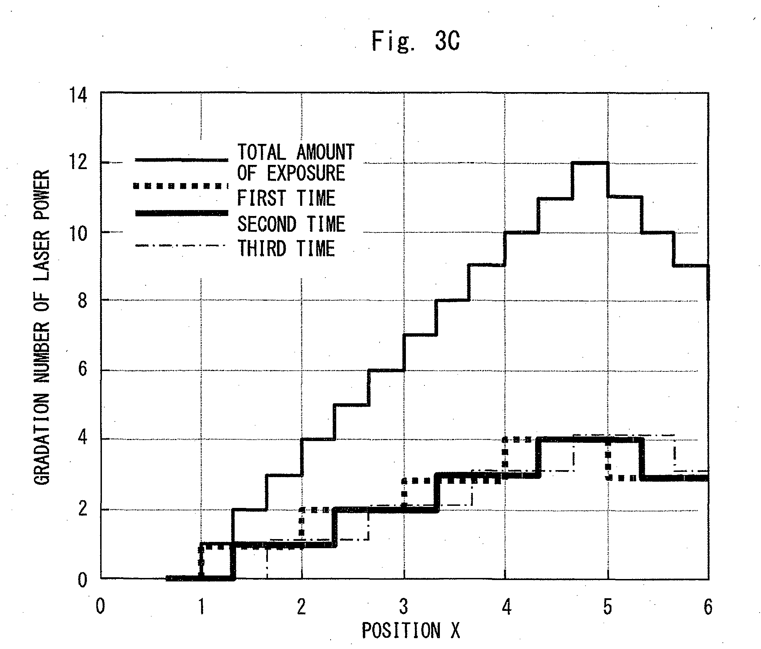

Fig. 3C is a graph showing still another example of gradation setting in the overlay exposure process of the microstructure production method according to an embodiment of the present invention;

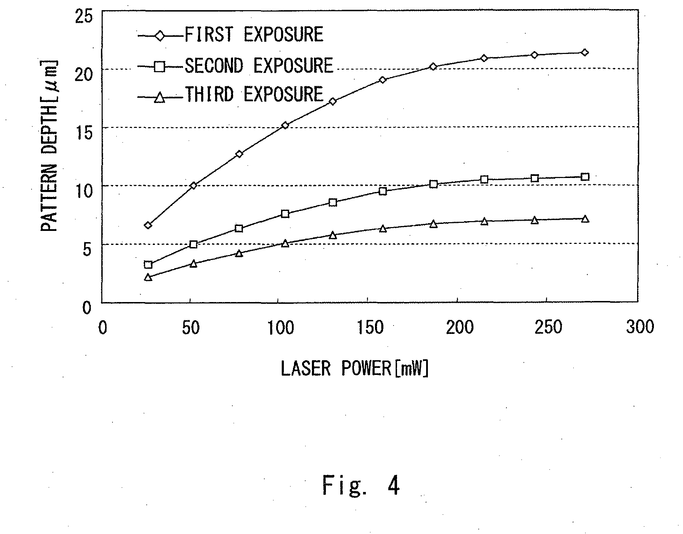

Fig. 4 is a graph for explaining a laser power setting example in the overlay exposure process of the microstructure production method according to an embodiment of the present invention;

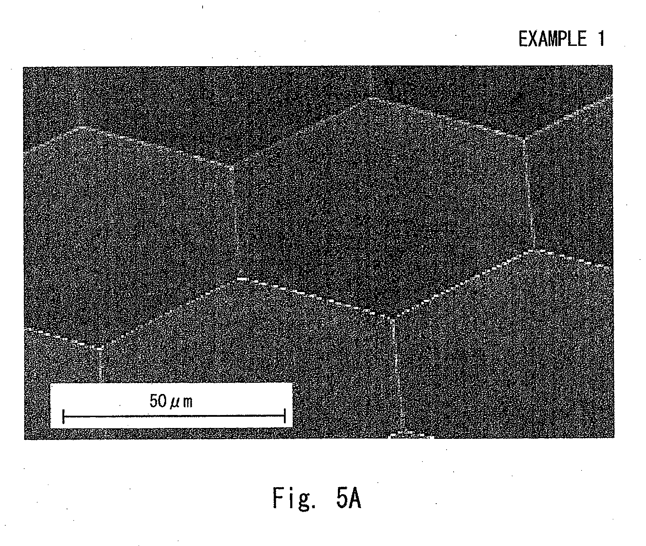

Fig. 5A is an SEM photograph showing a surface of a first stamper obtained in Example 1;

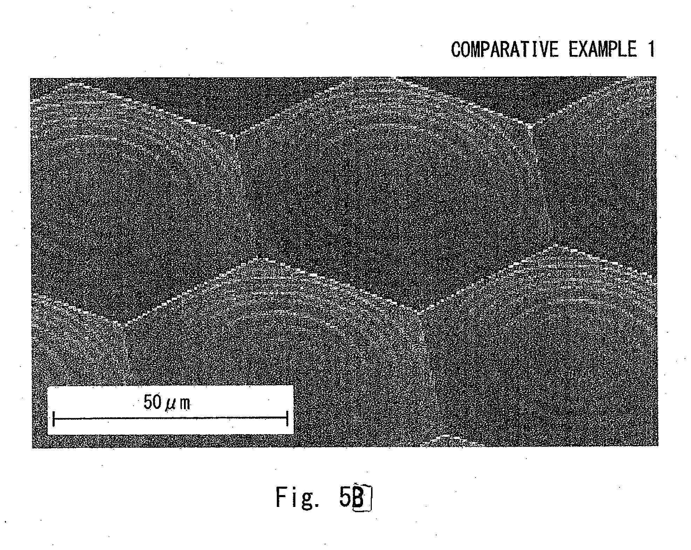

Fig. 5B is an SEM photograph showing a surface of a first stamper obtained in Comparative Example 1; and
Fig. 6 is a graph showing an example of gradation setting in the related art.

### "Microstructure Production Method and Microstructure"

A microstructure production method according to the present invention includes a photoresist pattern forming step of forming a photoresist pattern having a surface patterned with a concave and convex.

The microstructure production method according to the present invention may include a stamper forming step using a photoresist pattern, and a resin transfer step using a stamper.

A microstructure described herein is produced by the above-mentioned production method according to the present invention.

A microstructure production method according to an embodiment of the present invention will be described with reference to the drawings.

Figs. 1A to 1G and Figs. 2A to 2D are production process flow charts, each of which is a schematic sectional view.

Here, an example is described in which a photoresist pattern including a concave portion having a smoothly curved surface with a semicircular (semi-elliptical) shape in a cross-section view is produced; a first stamper is produced using the photoresist pattern; a second stamper (duplicate stamper) having an inverted pattern of the first stamper is produced; and a resin molding is produced using the second stamper.

This embodiment illustrates an example in which a lens sheet including a convex lens having a semicircular (semi-elliptical) shape in a cross-section view is produced as a resin molding.

The photoresist pattern, the stampers (including the duplicate stamper), and the resin molding are encompassed in the microstructure described herein.

Whether the concave and convex pattern of the photoresist pattern is formed into the same pattern as that of a resin molding as a product, or into the inverted pattern thereof, can be appropriately determined in consideration of various conditions, such as ease of fabricating the pattern shape and the number of replicating the stamper.

This embodiment illustrates an example in which a lens sheet including a convex lens having a semicircular (semi-elliptical) shape in a cross-section view is produced as a resin molding. Accordingly, a case where the concave and convex pattern of the photoresist pattern is formed into the inverted pattern of the pattern of the resin molding by using a positive photoresist will be described.

First, as shown in Fig. 1A, a positive photoresist 21 which is applied onto a base material 10 is exposed to light.

The film thickness of the photoresist 21 is not particularly limited as long as the film thickness is equal to or larger than a desired pattern with a concave and convex height.

A skin layer having different photosensitive characteristics from those of the inside of the photoresist 21 is generally formed on the surface layer of the photoresist 21. Accordingly, it is preferable that the film thickness of the photoresist 21 be designed so as to prevent the desired pattern with a concave and convex from being formed in the skin layer. The film thickness of the photoresist 21 is preferably greater than the height of the desired pattern with a concave and convex by 10% or more. In this case, however, if the film thickness of the photoresist 21 is extremely large, it is difficult to control the exposure, and a large number of resist materials are required. For this reason, it is not preferable to form the photoresist 21 with an extremely large film thickness.

It is preferable that a baking process be performed at a temperature from 70 to 110°C after the application of the photoresist 21 and before the exposure.

In this embodiment, the photoresist 21 is irradiated with laser light L1, which is collected by an objective lens (condenser lens) OL, by scanning the laser light while the amount of laser light (laser light intensity) is modulated.

In this embodiment, an overlay exposure process in which the exposure with a modulated amount of laser light is carried out one upon another and multiple times depending on an in-plane position of the base material 10. Setting of gradations in the overlay exposure process will be described later.

The laser light L1 to be used is not particularly limited. The laser light L1 is selected depending on the type of the photoresist 21 to be used.

Examples of the laser light L1 include Ar⁺ laser light (oscillation wavelength: 351 nm, 364 nm, 458 nm, 488 nm), Kr⁺ laser light (oscillation wavelength: 351 nm, 406 nm, 413 nm), He-Cd laser light (oscillation wavelength: 352 nm, 442 nm), pulsed light of a diode-pumped solid-state laser (oscillation wavelength: 355 nm, 473 nm), and semiconductor laser light (oscillation wavelength: 375 nm, 405 nm, 445 nm, 488 nm).

Next, as shown in Fig. 1B, the photoresist 21, which has been exposed to light, is developed to thereby obtain a photoresist pattern 22 having a surface which has a concave and convex pattern 22P.

The concave and convex pattern 22P includes at least one concave portion 22A having a smoothly curved surface with a semicircular (semi-elliptical) shape in a cross-section view.

In the illustrated example, the concave and convex pattern 22P includes a plurality of concave portions 22A.

A developer is not particularly limited and is selected according to the type of the photoresist 21. For example, an alkaline developer such as tetramethylammonium hydroxide (TMAH) can be used as the developer.

Next, as shown in Fig. 1C, a conductive film 30 made of a metal, such as nickel, is formed on the photoresist pattern 22 along the photoresist pattern shape by an evaporation method, an electroless plating method, or the like.

Next, as shown in Fig. 1D, a first stamper 40 made of a metal, such as nickel, is formed by an electrolytic plating method (electroforming) using the conductive film 30 as an electrode.

Next, as shown in Fig. 1E, the first stamper 40 is separated from the photoresist pattern 22.

The first stamper 40 has a concave and convex pattern 40P which is an inverted pattern of the concave and convex pattern 22P of the photoresist pattern 22.

Next, as shown in Figs. 1F and 1G, after a release process is performed on the surface of the first stamper 40, a second stamper (duplicate stamper) 45 made of a metal, such as nickel, is formed again by the electrolytic plating method. The second stamper 45 has a concave and convex pattern 45P which is an inverted pattern of the concave and convex pattern 40P of the first stamper 40. Accordingly, the concave and convex pattern 45P is the same as the concave and convex pattern 22P of the photoresist pattern 22.

Any process can be applied as the release process for the first stamper 40, as long as the first stamper 40 and the second stamper 45 can be released from each other after electro forming. For example, an oxidation layer forming process by oxygen plasma ashing is favorably used.

As shown in Fig. 2A, a base material 50 onto which a curable resin 61 is applied is separately prepared.

An energy ray-curable resin, which is hardened by irradiation of an energy ray such as an ultraviolet ray, or a thermosetting resin may be used as the curable resin 61. An energy ray-curable resin is preferably used as the curable resin 61.

Next, as shown in Fig. 2B, the second stamper 45 is pressed against the curable resin 61.

Next, as shown in Fig. 2C, the curable resin 61 is hardened. This figure illustrates a state in which an energy ray-curable resin is used as the curable resin 61 and is hardened by irradiation of an energy ray L2, such as an ultraviolet ray, onto the curable resin 61. After the curable resin 61 is hardened, a resin molding 62 is obtained.

Next, as shown in Fig. 2D, the resin molding 62 with the base material 50 is separated from the second stamper 45.

In this embodiment, a lens sheet including at least one convex lens is produced as the resin molding 62.

In the manner as described above, the photoresist pattern 22, the first stamper 40, the second stamper (duplicate stamper) 45, and the resin molding 62 are produced as microstructures.

According to the microstructure production method of this embodiment, in the exposure process for the photoresist 21 shown in Fig. 1A, the overlay exposure process in which the exposure with a modulated amount of the laser light L1 depending on the in-plane position of the base material 10 is carried out one upon another and multiple times is performed by setting gradation patterns with different relations between the in-plane position of the base material 10 and the amount of the laser light L1. Thus, the concave and convex pattern 22P according to the total amount of exposure of the overlay exposure process is formed after the development of the photoresist.

As described above, when the overlay exposure process is performed by setting gradation patters with different relations between the in-plane position of the base material 10 and the amount of the laser light L1, the number of gradations of the total amount of exposure is substantially increased as compared with the case of performing the exposure once. Consequently, the resolution can be improved and the concave and convex pattern 22P having a more smoothly curved surface can be formed.

Note that the term "the amount of exposure" refers to the amount of laser light. Under the same laser light irradiation conditions of, for example, a scanning rate, a laser light intensity distribution (objective lens numerical aperture), and a laser light scanning pitch, except that only laser power is changed, the amount of laser light corresponds to the laser power.

For example, in the overlay exposure process, the exposure of the photoresist can be carried out one upon another by using exposure pattern data different from that used in a previous exposure as exposure pattern data representing a relation between a relative position and the amount of laser light.

Also, in the overlay exposure process, the exposure of the photoresist can be carried out one upon another by using the same exposure pattern data as that used in a previous exposure as exposure pattern data representing a relation between a relative position and the amount of laser light and by shifting the in-plane position of the base material of the exposure pattern data.

In the overlay exposure process, assuming that the number of gradations for modulation of the amount of laser light is represented by N (N≥3) and the number of exposure overlays is represented by M (M≥2), the overlay exposure of the photoresist can be carried out in such a manner that an exposure region with an n-th (2≤n≤N-1) gradation in an ascending order of the amount of laser light in an m-th (2≤m≤M) exposure partially overlaps an exposure region with one of an (n-1)-th gradation and an (n+1)-th gradation in an ascending order of the amount of laser light in each exposure from a first exposure to an (m-1)-th exposure.

In this case, the number of gradations of the total amount of exposure of M times of the exposure overlay can be increased to M×N gradations.

In this case, the number of gradations can be substantially increased to M times the number of gradations obtained when the exposure of the photoresist is carried out once, and a finer gradation control can be performed. Consequently, a higher resolution can be obtained, and the concave and convex pattern 22P having a more smoothly curved surface can be formed.

In the overlay exposure process, it is preferable that a section width of a region in which the exposure region with the n-th (2≤n≤N-1) gradation in an ascending order of the amount of laser light in the m-th (2≤m≤M) exposure overlaps the exposure region with one of the (n-1)-th gradation and the (n+1)-th gradation in an ascending order of the amount of laser light in the first exposure be substantially m times as large as a width obtained by dividing a section width of the exposure region with one of the (n-1)-th gradation and the (n+1)-th gradation in an ascending order of the amount of laser light in the first exposure into M equal parts.

The phrase "substantially m times" used herein is defined as encompassing a range from 0.9 m times to 1.1 m times.

As described above, the section width of the region in which the exposure regions overlap each other in the overlay exposure process is divided substantially equally, thereby making it possible to suppress a variation in the set width of gradations for each amount of laser light and to form the concave and convex pattern 22P having a more smoothly curved surface.

Fig. 3A shows an example of gradation setting in the overlay exposure process when one concave portion 22A having an elliptical shape in a cross-section view is formed, and also shows an example of the total amount of exposure and gradation setting in each exposure when the overlay exposure process is performed using different exposure pattern data. Fig. 3A illustrates an example in which the exposure of the photoresist is carried out twice.

Fig. 3A is a graph showing the relation between the gradation number of the laser power (corresponding to the amount of laser light) and the in-plane position (position in the X-axis direction; in units of µm) of the base material in the section of the concave portion obtained after the development of the photoresist.

In this example, in each of first and second exposures, the gradations of the amount of laser light are set every 1 µm in the X-axis direction and the number of gradations is four (also in the Y-axis direction.

However, the exposure pattern data representing the relation between a relative position and the amount of laser light in the first exposure is different from that in the second exposure. In this example, the exposure pattern data of the second exposure is such exposure pattern data that only the gradation region including the center of a convex portion in a plan view is enlarged by 0.5 µm in positive and negative directions of each of the X-axis direction and the Y-axis direction in the first exposure pattern data.

The concave and convex pattern 22P according to the total amount of exposure of the two exposures is formed after the development of the photoresist. As shown in the figure, the total amount of exposure of the first exposure and the second exposure corresponds to 8 (2×4) gradations, and thus the number of gradations is substantially increased.

Fig. 3B shows an example of gradation setting in the overlay exposure process when one concave portion 22A having an elliptical shape in a cross-section view is formed, and also shows an example of the total amount of exposure and gradation setting in each exposure when the overlay exposure process is performed by using the same exposure pattern data and by shifting the in-plane position of the base material of the exposure pattern data. Fig. 3B illustrates an example in which the exposure of the photoresist is carried out twice.

Fig. 3B is a graph showing the relation between the gradation number of the laser power (corresponding to the amount of laser light) and the in-plane position (position in the X-axis direction; in units of µm) of the base material in the section of the concave portion obtained after the development of the photoresist.

In this example, in each of the first and second exposures, the gradations of the amount of laser light are set every 1 µm in the X-axis direction and the number of gradations is four (also in the Y-axis direction.

The exposure pattern data representing the relation between a relative position and the amount of laser light in the first exposure is the same as that in the second exposure. However, in the second exposure, the in-plane position of the base material of the exposure pattern data is shifted in the positive direction of the X-axis by 0.5 µm based on the first exposure.

The concave and convex pattern 22P according to the total amount of exposure of the two exposures is formed after the development of the photoresist. As shown in the figure, the total amount of exposure of the first exposure and the second exposure corresponds to 8 (2×4) gradations, and thus the number of gradations is substantially increased.

Fig. 3C shows an example of gradation setting in the overlay exposure process when one concave portion 22A having an elliptical shape in a cross-section view is formed, and also shows an example of the total amount of exposure and gradation setting in each exposure when the overlay exposure process is performed by using the same exposure pattern data and by shifting the in-plane position of the base material of the exposure pattern data.

Fig. 3C illustrates an example in which the exposure of the photoresist is carried out three times.

Fig. 3C is a graph showing the relation between the gradation number of the laser power (corresponding to the amount of laser light) and the in-plane position (position in the X-axis direction; in units of µm) of the base material in the section of the concave portion obtained after the development of the photoresist (the graph is partially omitted).

In this example, in each of first to third exposures, the gradations of the amount of laser light are set every 1 µm in the X-axis direction and the number of gradations is four (also in the Y-axis direction).

In the first to third exposures, the same exposure pattern data representing the relation between a relative position and the amount of laser light is used. However, in the second exposure, the in-plane position of the base material of the exposure pattern data is shifted in the positive direction of the X-axis by 1/3 (about 0.33) µm based on the first exposure, and in the third exposure, the in-plane position of the base material of the exposure pattern data is further shifted in the positive direction of the X-axis by 1/3 (about 0.33) µm based on the first exposure.

The concave and convex pattern 22P according to the total amount of exposure of the three exposures is formed after the development of the photoresist. As shown in the figure, the total amount of exposure of the first to third exposures corresponds to 12 (3×4) gradations, and thus the number of gradations is substantially increased.

As shown in Figs. 3A to Fig. 3C, the exposure with a modulated amount of laser light depending on the in-plane position of the base material is carried out one upon another and multiple times by setting gradation patters with different relations between the in-plane position of the base material and the amount of the laser light, thereby making it possible to increase the number of gradations of the total amount of exposure of overlay exposures, as compared with the case of performing the exposure once, and to improve the resolution. The number of gradations of the total amount of exposure of overlay exposures can be increased to twice the number of gradations obtained when the exposure of the photoresist is carried out once. Assuming that the number of times of exposure overlay is represented by M (M≥2), the number of gradations of the total amount of exposure of overlay exposures can be increased to M times the number of gradations obtained when the exposure of the photoresist is carried out once. As the number of times of exposure of the photoresist increases, the number of gradations of the total amount of exposure of overlay exposures increases. Accordingly, the resolution can be significantly improved, and the concave and convex pattern 22P having a more smoothly curved surface can be formed.

Setting of the amount of exposure in each exposure in the overlay exposure process is not particularly limited.

Assuming that the number of times of exposure overlay is represented by M (M≥2) and the desired total amount of exposure at a certain in-plane position of the base material is represented by R, the amount of exposure in each exposure at the position may be represented by, for example, R/M. Thus, setting of the amount of exposure at a certain in-plane position of the base material in each exposure facilitates setting of the amount of exposure in each exposure and makes it possible to obtain the desired concave and convex pattern 22P after the overlay exposure process and the development of the photoresist.

As mentioned above, the term "the amount of exposure" refers to the amount of laser light. Under the same laser light irradiation conditions of, for example, a scanning rate, a laser light intensity distribution (objective lens numerical aperture), and a laser light scanning pitch, except that only laser power is changed, the amount of laser light corresponds to the laser power.

Fig. 4 shows a laser power setting example in each exposure of the overlay exposure process.

Fig. 4 shows a relation between laser power and a pattern depth obtained after the development of the photoresist.

Assuming that the number of times of exposure overlay in the overlay exposure process is represented by M (M≥2) based on the relation (sensitivity curve) between the laser power and the pattern depth obtained after the development of the photoresist when the exposure of the photoresist is carried out only once, the laser power in each exposure is set in such a manner that the pattern depth is 1/M times a desired pattern depth.

Fig. 4 illustrates the relation between the laser power in each exposure and the pattern depth obtained after the development of the photoresist when the exposure of the photoresist is carried out twice and three times in the overlay exposure process.

According to the method of this embodiment, the number of gradations of the amount of laser light during the exposure of the photoresist can be substantially increased by a simple method, without the need for any modification of hardware or software of an exposure device, thereby improving the resolution.

The method of this embodiment is especially effective when the concave and convex pattern 22P including the concave portion 22A having a smoothly curved surface shape, such as a semicircular (semi-elliptical) shape in a cross-section view, is formed.

According to the method of this embodiment, the number of gradations of the amount of laser light during the exposure of the photoresist can be substantially increased to thereby improve the resolution. Accordingly, the surface shape of the concave portion 22A can be formed into a more smoothly curved surface shape.

In the method of this embodiment, for example, when the maximum diameter of the concave portion or the convex portion of the concave and convex pattern 22P of the photoresist pattern 22 is equal to or more than 2 µm, a surface roughness Ra in an evaluation length of 2 µm, which is measured by observation with an atomic force microscope, of each of the obtained photoresist pattern 22, stampers 40 and 45, and resin molding 62 can be set to 10 nm or less.

The method of this embodiment is especially effective when the concave and convex pattern 22P including the concave portion 22A having a smoothly curved surface, such as a semicircular (semi-elliptical) shape in a cross-section view, is formed. However, the method of this embodiment can be applied to formation of the concave and convex pattern 22P of any shape.

While Figs. 3A to 3C illustrate examples of gradation setting in one axial direction (X-axis direction) in the overlay exposure process, the same holds true for gradation setting in two axial directions (X-axis direction and Y-axis direction). The method of this embodiment can be applied also in this case, and the number of gradations can be substantially increased to thereby improve the resolution.

As described above, according to this embodiment, it is possible to provide the microstructure production method which includes the photoresist pattern forming step and is capable of substantially increasing the number of gradations of the amount of laser light by a simple method during the exposure of the photoresist, thereby improving the resolution.

### Examples

Examples and comparative examples according to the present invention will be described below.

In each example, a lens sheet (resin molding) including a plurality of dome-like convex lenses each having a diameter of 60 µm, a height of 6 µm, a hexagonal shape in a plan view, and a semicircular shape in a cross-section view was produced under the same conditions, except that only the photoresist exposure conditions were changed.

### (Example 1)

A positive photoresist was applied and exposed to light by the method of the above-described embodiment.

In this example, the exposure was carried out twice by setting gradation patterns with different relations between the in-plane position of the base material and the amount of laser light.

In the overlay exposure process, the exposure of the photoresist was carried out by using the same exposure pattern data as that used in the previous exposure as the exposure pattern data representing the relation between a relative position and the amount of laser light, and by shifting the in-plane position of the base material of the exposure pattern data.

In the exposure pattern data of the first exposure, the gradations were set every 1 µm in each of the X-axis direction and the Y-axis direction with respect to the diameter of 60 µm, and 32 gradations in total were set.

In the second exposure, the same exposure pattern data as that used in the first exposure was used, and the exposure of the photoresist was performed by shifting the first exposure pattern data in each of the X-axis direction and the Y-axis direction by 0.5 µm in the same manner as described above with reference to Fig. 3B.

The maximum laser power in each exposure was set to 12.5 mW which corresponds to 1/2 of 25 mW at which the height of 6 µm can be formed by one exposure of the photoresist.

After the exposure of the photoresist, a development process in which a resist substrate was immersed in an alkaline developer for 10 minutes was carried out to thereby obtain a photoresist pattern including a plurality of concave portions each having a diameter of 60 µm, a height of 6 µm, a hexagonal shape in a plain view, and a semicircular shape in a cross-section view.

A nickel film was deposited on the photoresist pattern along the photoresist pattern shape. After that, electrolytic plating was performed using the nickel film as an electrode, to thereby obtain a first nickel stamper having an inverted pattern of the concave and convex pattern of the photoresist pattern.

Fig. 5A is an SEM photograph showing the surface of the first stamper thus obtained.

Next, an oxidation layer serving as a release layer was formed by performing oxygen plasma ashing on the surface of the first stamper, and electrolytic plating was further performed, to thereby obtain a second nickel stamper (duplicate stamper) having the same pattern as the concave and convex pattern of the photoresist pattern.

The pattern was transferred to an ultraviolet curable resin, which was applied onto the base material, by using the obtained second stamper, to thereby obtain a lens sheet (resin molding) including a plurality of convex lenses each having a diameter of 60 µm, a height of 6 µm, a hexagonal shape in a plain view, and a semicircular shape in a cross-section view.

The lens sheet thus obtained was formed by replicating the concave and convex pattern of the first nickel stamper, and the lens sheet including the plurality of convex lenses each having a smooth surface was successfully produced. As a result of measuring the surface roughness Ra of each convex lens with an atomic force microscope (AFM), Ra was 4.1 nm in an evaluation length of 2 µm.

### (Example 2)

A photoresist pattern, first and second stampers, and a lens sheet were produced under the same conditions as those in Example 1, except that the exposure conditions were changed.

Also in this example, the exposure was carried out twice by setting gradation patterns with different relations between the in-plane position of the base material and the amount of laser light. However, in the overlay exposure process, the exposure of the photoresist was carried out using exposure pattern data different from that used in the previous exposure as the exposure pattern data representing the relation between a relative position and the amount of laser light.

In the first exposure, the gradations were set every 1 µm in each of the X-axis direction and the Y-axis direction with respect to the diameter of 60 µm, and 32 gradations in total were set. In the second exposure, the exposure pattern data was obtained by enlarging only the gradation region including the center of the convex portion in a plan view by 0.5 µm in the positive and negative directions of each of the X-axis direction and the Y-axis direction in the first exposure pattern data, in the same manner as described above with reference to Fig. 3A.

The maximum laser power in each exposure was set to 12.5 mW which corresponds to 1/2 of 25 mW at which the height of 6 µm can be formed by one exposure of the photoresist.

As in Example 1, the lens sheet including the plurality of convex lenses each having a smooth surface was successfully produced. As a result of measuring the surface roughness Ra of each convex lens with an atomic force microscope (AFM), Ra was 4.5 nm in an evaluation length of 2 µm.

### (Comparative Example 1)

A photoresist pattern, first and second stampers, and a lens sheet were produced in the same manner as in Example 1, except that the exposure conditions were changed.

In this example, the overlay exposure process was not carried out and the exposure was carried out once.

The gradations were set every 1 µm in each of the X-axis direction and the Y-axis direction with respect to the diameter of 60µm, and 32 gradations in total were set.

The maximum laser power was set to 25 mW at which the height of 6 µm can be formed by one exposure of the photoresist.

Fig. 5B is an SEM photograph showing the surface of the obtained first stamper.

A concentric pattern was generated on the surface of each convex lens of the lens sheet, which was formed by replicating the concave and convex pattern of the first stamper. Thus, the ability to focus light was poor. As a result of measuring the surface roughness Ra of each convex lens with an atomic force microscope (AFM), Ra was 100 nm in an evaluation length of 2 µm.

The present invention is applicable to any microstructure production method including a photoresist pattern forming step of forming a photoresist pattern having a surface patterned with a concave and convex by performing the exposure and development on a positive photoresist applied onto a base material.

The present invention is also applicable to a photoresist pattern having a surface patterned with a concave and convex; a stamper produced by using the photoresist pattern; a duplicate stamper obtained by turning over the pattern shape of the stamper one or more times; and a resin molding produced by transferring the pattern onto a resin by using the stampers.

This application is based upon and claims the benefit of priority from Japanese patent application No. 2012-219440, filed on October 1, 2012.

### Reference Signs List

- 10: BASE MATERIAL
- 21: PHOTORESIST
- 22: PHOTORESIST PATTERN
- 22P: CONCAVE AND CONVEX PATTERN
- 22A: CONVEX PORTION
- 30: CONDUCTIVE FILM
- 40: FIRST STAMPER
- 40P: CONCAVE AND CONVEX PATTERN
- 45: SECOND STAMPER (DUPLICATE STAMPER)
- 45P: CONCAVE AND CONVEX PATTERN
- 50: BASE MATERIAL
- 61: CURABLE RESIN
- 62: RESIN MOLDING
- L1: LASER LIGHT
- L2: ENERGY RAY

## Claims

1. A microstructure production method comprising:
a photoresist pattern (22) forming step of irradiating a positive photoresist (21) applied onto a base material (10, 50) with laser light (L1) while scanning the laser light (L1) to expose the photoresist (21) to light, and developing the photoresist (21), thereby forming a photoresist pattern (22) having a surface patterned with a concave and convex,
wherein in the photoresist pattern (22) forming step, an overlay exposure process in which exposure of a plurality of gradations with a modulated amount of laser light (L1) depending on an in-plane position of the base material (10, 50) is carried out one upon another and multiple times is performed by setting gradation patterns with different relations between the in-plane position of the base material (10, 50) and the amount of laser light (L1) so that the number of gradations of a total amount of exposure in the overlay exposure process is increased compared to the number of gradations of the modulation of the amount of the laser light (L1), and the concave and convex pattern (22P) according to the total amount of exposure in the overlay exposure process is formed after developing the photoresist (21), and
in the overlay exposure process, the exposure of the photoresist (21) is carried out one upon another by using exposure pattern data different from that used in a previous exposure as exposure pattern data representing a relation between a relative position and the amount of laser light (L1), or is carried out one upon another by using the same exposure pattern data as that used in a previous exposure as exposure pattern data representing a relation between a relative position and the amount of laser light (L1) and by shifting the in-plane position of the base material (10, 50) of the exposure pattern data.

2. The microstructure production method according to Claim 1, wherein in the overlay exposure process, assuming that the number of gradations for modulation of the amount of laser light (L1) is represented by N (N≥3) and the number of times of exposure overlay is represented by M (M≥2), the overlay exposure of the photoresist (21) is carried out in such a manner that an exposure region with an n-th (2≤n≤N-1) gradation in an ascending order of the amount of laser light (L1) in an m-th (2≤m≤M) exposure partially overlaps an exposure region with one of an (n-1)-th gradation and an (n+1)-th gradation in an ascending order of the amount of laser light (L1) in each exposure from a first exposure to an (m-1)-th exposure, to thereby increase the number of gradations of the total amount of exposure of M times of the exposure overlay to MxN gradations.

3. The microstructure production method according to Claim 2, wherein in the overlay exposure process, a section width of a region in which the exposure region with the n-th (2≤n≤N-1) gradation in an ascending order of the amount of laser light (L1) in the m-th (2≤m≤M) exposure overlaps the exposure region with one of the (n-1)-th gradation and the (n+1)-th gradation in an ascending order of the amount of laser light (L1) in the first exposure is substantially m times as large as a width obtained by dividing a section width of the exposure region with one of the (n-1)-th gradation and the (n+1)-th gradation in an ascending order of the amount of laser light (L1) in the first exposure into M equal parts.

4. The microstructure production method according to any one of Claims 1 to 3, further comprising a stamper (40) forming step of forming a stamper (40) on the photoresist pattern (22) along a pattern shape of the photoresist pattern (22), and separating the stamper (40) from the photoresist pattern (22).

5. The microstructure production method according to Claim 4, further comprising a resin transfer step of transferring a pattern onto a resin by using a duplicate stamper (45), the duplicate stamper (45) being obtained by turning over the stamper (40) or a pattern shape of the stamper (40) one or more times.

## Patentansprüche

1. Mikrostrukturherstellungsverfahren, umfassend:
einen Schritt zum Bilden eines Fotolackmusters (22) des Bestrahlens eines positiven Fotolacks (21), der auf ein Basismaterial (10, 50) aufgebracht ist, mit Laserlicht (L1), während das Laserlicht (L1) gerastert wird, um den Fotolack (21) Licht auszusetzen, und des Entwickelns des Fotolacks (21), wodurch ein Fotolackmuster (22) mit einer Oberfläche, die mit einem konkaven und konvexen Muster versehen ist, gebildet wird,
wobei in dem Schritt zum Bilden eines Fotolackmusters (22) ein Überlagerungsbelichtungsverfahren durchgeführt wird, bei dem das Belichten einer Mehrzahl von Abstufungen mit einer modulierten Menge an Laserlicht (L1) in Abhängigkeit von einer Position einer Bezugsebene des Basismaterials (10, 50) übereinander und mehrfach durchgeführt wird, indem Abstufungsmuster mit unterschiedlichen Beziehungen zwischen der Position einer Bezugsebene des Basismaterials (10, 50) und der Menge an Laserlicht (L1) eingestellt werden, so dass die Anzahl der Abstufungen einer Gesamtmenge an Belichtung in dem Überlagerungsbelichtungsverfahren im Vergleich zu der Anzahl der Abstufungen der Modulation der Menge des Laserlichts (L1) erhöht wird, und das konkave und konvexe Muster (22P) entsprechend der Gesamtmenge an Belichtung in dem Überlagerungsbelichtungsverfahren nach der Entwicklung des Fotolacks (21) gebildet wird, und
in dem Überlagerungsbelichtungsverfahren die Belichtung des Fotolacks (21) unter Verwendung von Belichtungsmusterdaten, die sich von denen, die in einer früheren Belichtung als Belichtungsmusterdaten, die eine Beziehung zwischen einer relativen Position und der Menge an Laserlicht (L1) darstellen, verwendet wurden, unterscheiden, übereinander durchgeführt wird, oder unter Verwendung derselben Belichtungsmusterdaten, die bei einer früheren Belichtung als Belichtungsmusterdaten, die eine Beziehung zwischen einer relativen Position und der Menge an Laserlicht (L1) darstellen, verwendet wurden, und durch Verschieben der Position einer Bezugsebene des Basismaterials (10, 50) der Belichtungsmusterdaten übereinander durchgeführt wird.

2. Mikrostrukturherstellungsverfahren nach Anspruch 1, wobei in dem Überlagerungsbelichtungsverfahren unter der Annahme, dass die Anzahl der Abstufungen zum Modulieren der Laserlichtmenge (L1) durch N (N≥3) dargestellt wird und die Anzahl der Belichtungsüberlagerungen durch M (M≥2) dargestellt wird, die Überlagerungsbelichtung des Fotolacks (21) so durchgeführt wird, dass ein Belichtungsbereich mit einer n-ten (2≤n≤N-1) Abstufung in einer aufsteigenden Reihenfolge der Menge an Laserlicht (L1) in einer m-ten (2≤m≤M) Belichtung einen Belichtungsbereich mit einer (n-1)-ten Abstufung und einer (n+1)-ten Abstufung in einer aufsteigenden Reihenfolge der Menge an Laserlicht (L1) in jeder Belichtung von einer ersten Belichtung zu einer (m-1)-ten Belichtung teilweise überlappt, um dadurch die Anzahl der Abstufungen der Gesamtbelichtungsmenge von M mal der Belichtungsüberlagerung auf MxN-Abstufungen zu erhöhen.

3. Mikrostrukturherstellungsverfahren nach Anspruch 2, wobei in dem Überlagerungsbelichtungsverfahren eine Abschnittsbreite eines Bereichs, in dem der Belichtungsbereich mit der n-ten (2≤n≤N-1) Abstufung in einer aufsteigenden Reihenfolge der Menge an Laserlicht (L1) in der m-ten (2≤m≤M) Belichtung den Belichtungsbereich mit einer der (n-1)-ten Abstufung und der (n+1)-ten Abstufung in einer aufsteigenden Reihenfolge der Menge an Laserlicht (L1) in der ersten Belichtung überlappt, im Wesentlichen m mal so groß ist wie eine Breite, die durch Teilen einer Abschnittsbreite des Belichtungsbereichs mit einer der (n-1)-ten Abstufung und der (n+1)-ten Abstufung in einer aufsteigenden Reihenfolge der Menge an Laserlicht (L1) in der ersten Belichtung in M gleiche Teile erhalten wird.

4. Mikrostrukturherstellungsverfahren nach einem der Ansprüche 1 bis 3, weiter umfassend einen Schritt zum Bilden einer Matrize (40) des Bildens einer Matrize (40) auf dem Fotolackmuster (22) entlang einer Musterform des Fotolackmusters (22), und des Trennens der Matrize (40) von dem Fotolackmuster (22).

5. Mikrostrukturherstellungsverfahren nach Anspruch 4, weiter umfassend einen Harzübertragungsschritt des Übertragens eines Musters auf ein Harz unter Verwendung einer Duplikatsmatrize (45), wobei die Duplikatsmatrize (45) erhalten wird, indem die Matrize (40) oder eine Musterform der Matrize (40) ein- oder mehrmals übertragen wird.

## Revendications

1. Procédé de production de microstructures comprenant :
une étape de formation de motifs de résine photosensible (22) consistant à irradier une résine photosensible positive (21) appliquée sur un matériau de base (10, 50) avec une lumière laser (L1) tout en balayant la lumière laser (L1) pour exposer la résine photosensible (21) à de la lumière, et développer la résine photosensible (21), formant ainsi un motif de résine photosensible (22) ayant une surface avec des motifs concaves et convexes,
dans lequel, dans l'étape de formation de motifs de résine photosensible (22), un processus d'exposition par superposition, dans lequel l'exposition d'une pluralité de gradations avec une quantité modulée de lumière laser (L1) dépendant d'une position du matériau de base (10, 50) dans le plan est effectuée de manière empilée et de multiples fois, est réalisé en définissant des motifs de gradation avec différentes relations entre la position du matériau de base (10, 50) dans le plan et la quantité de lumière laser (L1) de telle sorte que le nombre de gradations d'une quantité totale d'exposition dans le processus d'exposition par superposition est augmenté par rapport au nombre de gradations de la modulation de la quantité de la lumière laser (L1), et le motif concave et convexe (22P) en fonction de la quantité totale d'exposition dans le processus d'exposition par superposition est formé après le développement de la résine photosensible (21), et
dans le processus d'exposition par superposition, l'exposition de la résine photosensible (21) est effectuée de manière empilée en utilisant des données de motif d'exposition différentes de celles utilisées dans une exposition précédente en tant que données de motif d'exposition représentant une relation entre une position relative et la quantité de lumière laser (L1), ou est effectuée de manière empilée en utilisant les mêmes données de motif d'exposition que celles utilisées dans une exposition précédente en tant que données de motif d'exposition représentant une relation entre une position relative et la quantité de lumière laser (L1) et en décalant la position du matériau de base (10, 50) dans le plan dans les données de motif d'exposition.

2. Procédé de production de microstructures selon la revendication 1, dans lequel, dans le processus d'exposition par superposition, en supposant que le nombre de gradations pour la modulation de la quantité de lumière laser (L1) est représenté par N (N ≥ 3) et le nombre d'opérations de superposition d'exposition est représenté par M (M ≥ 2), l'exposition par superposition de la résine photosensible (21) est effectuée d'une manière telle qu'une région d'exposition avec une n-ième (2 ≤ n ≤ N-1) gradation dans un ordre croissant de la quantité de lumière laser (L1) dans une m-ième (2 ≤ m ≤ M) exposition chevauche partiellement une région d'exposition avec l'une d'une (n-1)-ième gradation et d'une (n+1)-ième gradation dans un ordre croissant de la quantité de lumière laser (L1) dans chaque exposition d'une première exposition à une (m-1)-ième exposition, pour ainsi augmenter le nombre de gradations de la quantité totale d'exposition de M fois la superposition d'exposition à M x N gradations.

3. Procédé de production de microstructures selon la revendication 2, dans lequel, dans le processus d'exposition par superposition, une largeur de section d'une région dans laquelle la région d'exposition avec la n-ième (2 ≤ n ≤ N-1) gradation dans un ordre croissant de la quantité de lumière laser (L1) dans la m-ième (2 ≤ m ≤ M) exposition chevauche la région d'exposition avec l'une de la (n-1)-ième gradation et la (n+1)-ième gradation dans un ordre croissant de la quantité de lumière laser (L1) dans la première exposition est sensiblement m fois plus grande que la largeur obtenue en divisant une largeur de section de la région d'exposition avec l'une de la (n-1)-ième gradation et la (n+1)-ième gradation dans un ordre croissant de la quantité de lumière laser (L1) dans la première exposition en M parties égales.

4. Procédé de production de microstructures selon l'une quelconque des revendications 1 à 3, comprenant en outre une étape de formation d'estampeur (40) consistant à former un estampeur (40) sur le motif de résine photosensible (22) selon une forme de motif du motif de résine photosensible (22), et séparer l'estampeur (40) du motif de résine photosensible (22).

5. Procédé de production de microstructures selon la revendication 4, comprenant en outre une étape de transfert de résine consistant à transférer un motif sur une résine en utilisant un estampeur de duplication (45), l'estampeur de duplication (45) étant obtenu en retournant l'estampeur (40) ou une forme de motif de l'estampeur (40) une ou plusieurs fois.
